# EUROPÄISCHE PATENTSCHRIFT

(11) **EP 0 875 085 B1**
(45) Veröffentlichungstag und Bekanntmachung des Hinweises auf die Patenterteilung: **11.08.1999**
(21) Anmeldenummer: 96944632.7
(22) Anmeldetag: 20.12.1996
(51) Int. Cl.: H02B 1/30, H05K 9/00

(54) **VORRICHTUNG ZUM ELEKTRISCH LEITENDEN VERBINDEN EINER IN EINEM SCHALTSCHRANK EINGEBAUTEN MONTAGEPLATTE**
DEVICE FOR CREATING AN ELECTRICALLY CONDUCTING CONNECTION FOR AN ASSEMBLY PANEL FITTED IN A SWITCH CABINET
DISPOSITIF DE CONNEXION ELECTROCONDUCTRICE D'UNE PLAQUE DE MONTAGE ENCASTREE DANS UNE ARMOIRE DE DISTRIBUTION

(30) Priorität: 17.01.1996 DE 19601458; 04.07.1996 DE 29611660 U
(43) Veröffentlichungstag der Anmeldung: 04.11.1998
(73) Patentinhaber: Rittal-Werk Rudolf Loh GmbH & Co. KG, 35745 Herborn (DE)
(72) Erfinder: MÜNCH, Udo, D-35764 Sinn (DE); REUTER, Wolfgang, D-57299 Burbach 5 (DE)
(74) Vertreter: Fleck, Hermann-Josef, Dr.-Ing.
(86) Internationale Anmeldenummer: EP9605797
(87) Internationale Veröffentlichungsnummer: WO9726690

(56) Entgegenhaltungen:
- EP-A- 0 634 550
- DE-C- 4 110 800
- DE-C- 19 540 300
- DE-U- 9 414 036
- US-A- 4 803 306

## Beschreibung

Die Erfindung betrifft eine Vorrichtung zum elektrisch leitenden Verbinden einer parallel zur Rückseite in einem Schaltschrank eingebauten Montageplatte gemäß dem Oberbegriff des Anspruch 1 bzw. des Anspruch 6.

Soll eine Montageplatte im Schaltschrank elektrisch leitend mit dem Rahmengestell oder dem Schrankkorpus verbunden werden, dann sind an der Montageplatte und dem Rahmengestell oder dem Schrankkorpus Anschlußstellen zu schaffen, die über Erdungskabel miteinander verbunden werden. Dazu sind gerade an der Montageplatte entsprechende Vorkehrungen zu treffen, und die Kontaktierung kann erst bei eingesetzter Montageplatte vollzogen werden. Dies ist nicht einfach durchzuführen, insbesondere dann, wenn die Montageplatte unmittelbar im Anschluß an die Rückwand in den Schaltschrank eingebaut ist.

In der US-A 4,803,306 ist eine Vorrichtung zum elektrisch leitenden Verbinden einer in einem Schaltschrank, Rahmengestell oder Gehäuse eingebauten Platte mit einer Abkantung einer weiteren Platte gezeigt. Dabei ist an einem U-förmig abgekanteten freien Endabschnitt der einen Platte in einem darin vorgesehenen Durchbruch eine Kontaktfeder mit einem V-förmigen mit Haltekrallen versehenen Halteabschnitt festgelegt. An dem U-Steg steht eine nach außen gewölbte Kontaktkante zur Kontaktierung an einem gegenüberliegenden U-Steg der anderen Platte vor.

In der DE-C 41 10 800 ist eine weitere Vorrichtung zum elektrisch leitenden Verbinden zweier Gehäuseteile mittels einer Kontaktfeder gezeigt. Dabei ist die Kontaktfeder mit einem U-förmigen Abschnitt auf einen Längssteg an der Rückseite einer Frontplatte aufgeschoben.

Es ist Aufgabe der Erfindung, eine Vorrichtung der eingangs erwähnten Art zu schaffen, bei der bei Einsetzen der Montageplatte automatisch die Kontaktierung zum Rahmengestell oder zum Schrankkorpus des Schaltschrankes erfolgen kann und die Anbringung der Kontaktfeder einfach und stabil ist.

Diese Aufgabe wird nach der Erfindung durch die Merkmale des Anspruch 1 oder alternativ durch die Merkmale des Anspruch 6 gelöst.

Mit Hilfe der einfachen und billig herstellbaren Kontaktfedern, die vor dem Einsetzen der Montageplatte am Rand derselben festgelegt werden können, lassen sich beim Einsetzen der Montageplatte an beliebig vielen Stellen elektrisch leitende Verbindungen zu den angrenzenden Rahmenschenkeln des Rahmengestelles, Montageschienen oder Abkantungen der Seitenwände automatisch herstellen, da die Kontaktabschnitte der Kontaktfedern unter Verspannung an diesen zur Anlage kommen und elektrisch leitende Verbindungen zu diesen mit einer elektrisch leitenden Oberfläche versehenen Teilen des Schaltschrankes herstellen. Dabei spielt es keine Rolle, ob die Montageplatte mit elektrisch leitender Oberfläche oder mit elektrisch nichtleitender Oberflächenschutzschicht versehen ist. Die Haltekrallen durchstoßen beim Aufstecken der Kontaktfeder auf den Endabschnitt des Randes der Montageplatte die Oberflächenschutzschicht und stellen unter Vorspannung elektrisch leitende Verbindungen zur Montageplatte her. Dabei ist vorgesehen, daß der Rand der Montageplatte U-förmig so abgekantet ist, daß der Endabschnitt parallel zur Rückwand verläuft und dieser zugekehrt ist und daß die Kontaktabschnitte den Rand der Montageplatte teilweise umschließen. Damit wird ein besserer Halt der Kontaktfeder auf dem Endabschnitt des Randes der Montageplatte erreicht. Außerdem wird beim Einsetzen der Montageplatte über die Kontaktabschnitte keine Kraftkomponente ausgeübt, die zum Lösen der Kontaktfeder vom Rand der Montageplatte führen könnte.

Alternativ sind die Kontaktfedern an dem Rahmenschenkel, der Montageschiene oder der rahmenschenkelartigen Abkantung einer Oberflächenschicht durchstoßend festgelegt und treten mit dem gegebenenfalls blanken Randbereich der Montageplatte in Kontakt, ohne daß zusätzliche Handgriffe erforderlich sind.

Bei der alternativen Ausführung gemäß Anspruch 6 ist bei zuverlässiger Funktion die Ausbildung und Anbringung der Kontaktfedern an dem Rahmenschenkel, der Montageschiene oder der rahmenschenkelartigen Abkantung einfach, und es wird eine stabile Abstützung geboten.

Nach einer Ausgestaltung ist vorgesehen, daß die Haltekrallen an dem innenliegenden Halteabschnitt seitlich ausgestanzt und in Richtung zum außenliegenden Halteabschnitt eingebogen sind.

Ist nach einer Ausgestaltung vorgesehen, daß die Kontaktabschnitte breiter als die Halteabschnitte sind und daß die Haltekrallen in Richtung zum Ende des Endabschnittes des Randes der Montageplatte gerichtet sind, dann kann die Kontaktfeder aus einem Streifen von Federbandstahl einfach als Stanz-Biegeteil hergestellt werden.

Eine weitere Ausgestaltung sieht vor, daß die Kontaktabschnitte der Kontaktfeder an den abgerundeten Übergängen des Mittelabschnittes des Randes der Montageplatte außen anliegen. Auf diese Weise verbessern auch die Kontaktabschnitte den Halt der Kontaktfeder auf dem Rand der Montageplatte.

Falls erforderlich, kann die Anschlußmöglichkeit für ein Erdungskabel dadurch auf einfache Art geschaffen werden, daß der der Rückwand abgekehrte Kontaktabschnitt der Kontaktfeder als Anschlußabschnitt verlängert ist, der eine Anschlußbohrung aufweist und/oder in Aufsteckkontakten endet, sowie in Richtung zur Kontaktkante abgekantet ist. Der Rahmenschenkel des Rahmengestelles, die Montageschiene oder die Abkantung der Seitenwand kann dann auch mit einer Oberflächenschutzschicht versehen sein.

Vorteilhafte Maßnahmen bestehen auch in den Merkmalen des Anspruchs 7.

Die Erfindung wird anhand eines in der Zeichnung dargestellten Ausführungsbeispiels näher erläutert. Es zeigen:
- Fig. 1: im Teilabschnitt eine mittels einer erfindungsgemäßen Kontaktfeder hergestellte, elektrisch leitende Verbindung zwischen einer im Bereich des hinteren Rahmens des Rahmengestelles eines Schaltschrankes eingebauten Montageplatte mit Oberflächenschutzschicht mit dem Rahmengestell,
- Fig. 2 und 3: die dafür verwendete Kontaktfeder in zwei um 90° versetzten Ansichten,
- Fig. 4: Ausführungsbeispiele für das Ende des Anschlußabschnittes der Kontaktfeder,
- Fig. 5: ein weiteres Ausführungsbeispiel einer erfindungsgemäßen Kontaktfeder in perspektivischer Darstellung und
- Fig. 6, 7 und 8: Einbaubeispiele für die Kontaktfeder nach Fig. 5

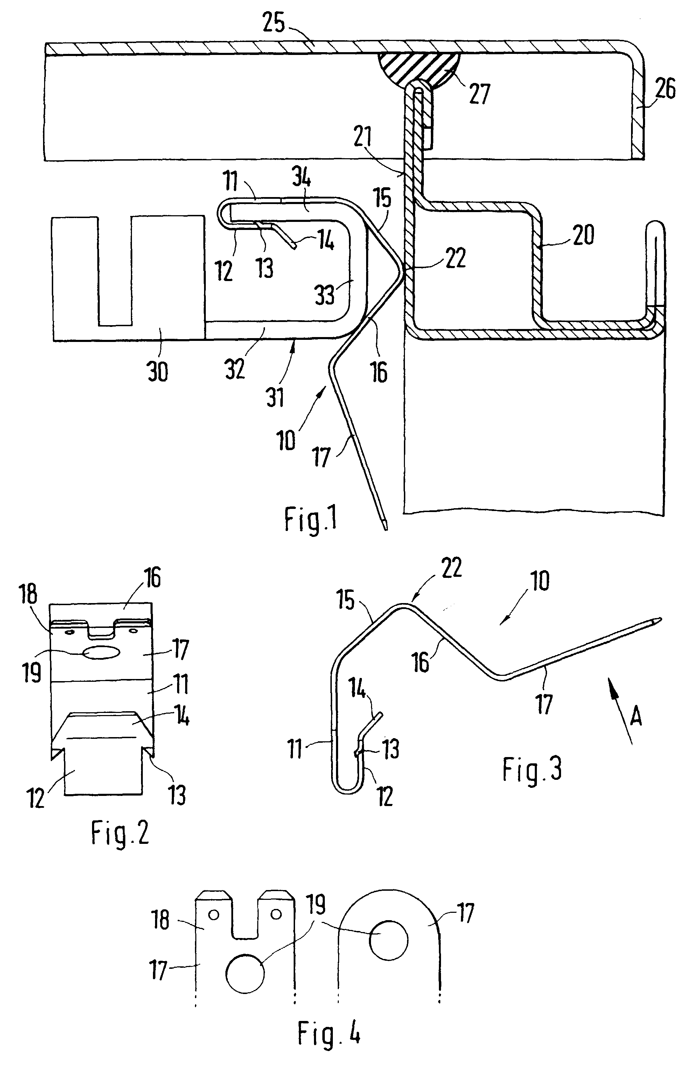

Wie Fig.1 erkennen läßt, bilden Rahmenschenkel 20 im Bereich der Rückseite des Schaltschrankes einen Rahmen, wobei eine als Dichtungssteg verlängerte Profilseite der Rahmenschenkel 20 eine Anlagewand bildet. Die mit abgekantetem Rand 26 versehene Rückwand 25 trägt auf ihrer Innenseite ein Dichtungselement 27, das an dem Dichtungssteg anliegt und eine dichte Verbindung zwischen Rückwand 25 und Rahmenschenkel 20 ermöglicht. Anstelle des Rahmenschenkels 20 kann auch eine rahmenschenkelartige Abkantung der zugeordneten Seitenwand auch die Anlagewand 21 bilden. Außerdem kann bei von der Rückwand abgesetzten Einbau der Montageplatte 30 auch eine Montageschiene die Anlagewand 21 bilden. Kontaktstellen, wie sie in Fig. 1 gezeigt sind, können an allen vier Seiten der Montageplatte 30 gebildet werden. Dies hängt nur von der Randausbildung der Montageplatte 30 und der Zuordnung von Anlagewänden 21 für die Kontaktfeder 10 ab. Vorzugsweise werden beide vertikalen Seiten der Montageplatte 30 mit einen U-förmig abgekanteten Rand 31 versehen. Dabei gehen der Seitenabschnitt 31 und der Endabschnitt 34 abgerundet in den Mittelabschnitt 33 über, der den Rand 31 nach außen abschließt. Der Endabschnitt 34 verläuft parallel zur Rückwand 25 und ist dieser zugekehrt.

Die nach Fig. 1 und 3 abgekantete Kontaktfeder 10 bildet mit den Halteabschnitten 11 und 12 eine Steckaufnahme, die auf das Ende des Endabschnittes 34 aufgesteckt wird. Der Endabschnitt 14 des Halteabschnittes 12 ist vom Halteabschnitt 11 weggebogen, damit das Aufstecken der Kontaktfeder 10 auf dem Endabschnitt 34 des Randes 31 der Montageplatte 30 nicht erschwert wird und die Vorspannung zwischen den Halteabschnitten 11 und 12 durch Auslenken derselben erleichtert wird. Am Halteabschnitt 12 sind seitlich Haltekrallen 13 aufgestanzt und in Richtung zum Halteabschnitt 11 eingebogen. Außerdem sind die Haltekrallen 13 in Richtung zum Ende des Endabschnittes 34 gerichtet, um den Halt der aufgesteckten Kontaktfeder 10 zu verbessern. Der äußere Halteabschnitt 11 geht in die beiden Kontaktabschnitte 15 und 16 über, die den Rand 31 der Montageplatte 30 umschließen und an den abgerundeten Übergängen zum Mittelabschnitt 33 des Randes 31 anliegen. Außerdem bilden die beiden Kontaktabschnitte 15 und 16 eine Kontaktkante 22, die an der Anlagewand 21 unter Vorspannung anliegt. Gleichzeitig legen sich die Kontaktabschnitte 15 und 16 unter Vorspannung am Rand 31 der Montageplatte 30 an und verbessern den Halt der Kontaktfeder 10 an der Kontaktplatte 10.

Beim Einsetzen der Montageplatte 30 werden die Kontaktabschnitte 15 und 16 der Kontaktfeder 30 in Richtung zum Mittelabschnitt 33 des Randes 31 gedrückt. Dadurch entsteht die Vorspannung für die Kontaktkante 22. Der Kontaktabschnitt 16 macht am Rand 31 eine kleine Gleitbewegung, ohne den Halt am Rand 31 zu verschließen und ohne die Vorspannung zwischen den beiden Kontaktabschnitten 15 und 16 aufzuheben.

Wie Fig. 2 erkennen läßt, ist zumindest der Halteabschnitt 12 schmäler als die Übrigen Abschnitte der Kontaktfeder, so daß die Kontaktfeder 10 mit den Haltekrallen 13 am Halteabschnitt 12 aus einem einheitlichen breiten Streifen aus Federbandstahl als Stanz-Biegeteil hergestellt werden.

Hat die Anlagewand 21 eine elektrisch nichtleitende Oberflächenschutzschicht, dann ist der Kontaktabschnitt 16 als Anschlußabschnitt 17 verlängert und dabei in Richtung zur Anlagewand 21 abgekantet. Wie die Fig. 4 zeigt, dann das Ende des Anschlußabschnittes 17 mit einer Anschlußbohrung 18 versehen sein, die das Anschließen eines Erdungskabel erleichtert. Das Ende kann zudem auch in Steckanschlüsse auslaufen, die als Aufsteckkontakt 18 ausgebildet sein können. Damit läßt sich ebenfalls eine elektrisch leitende Verbindung der Montageplatte 30 mit dem übrigen Schaltschrankaufbau herstellen.

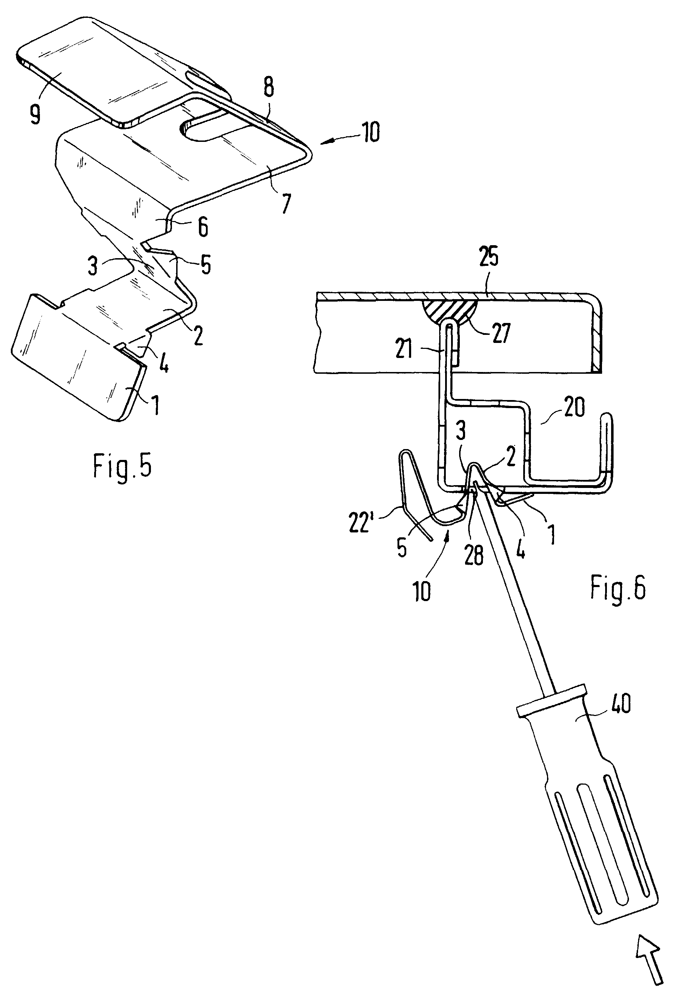

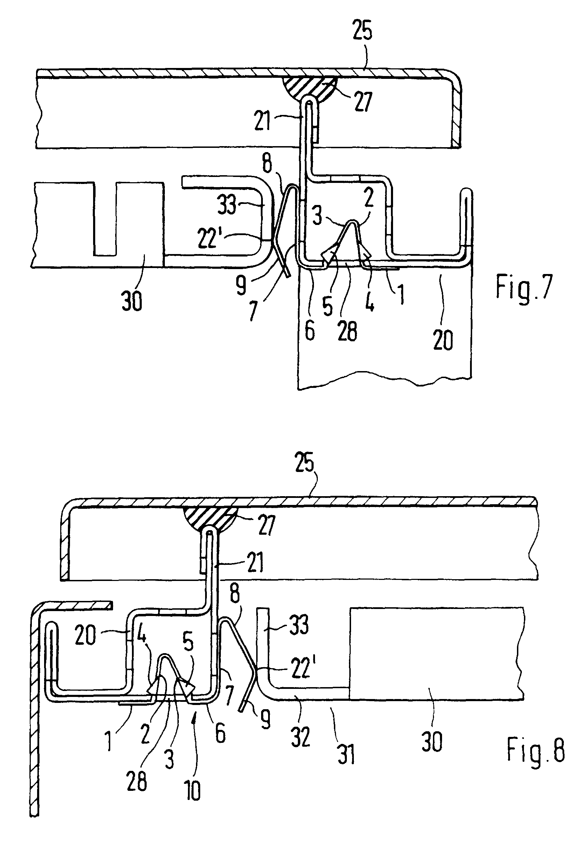

Die Fig. 5 bis 8 zeigen eine alternative Ausführungsform der Kontaktfeder 10. In Fig. 5 ist eine perspektivische Darstellung der Kontaktfeder 10 gezeigt. Fig. 6 zeigt die Vorgehensweise beim Anbringen der Kontaktfeder 10 an einem Druchbruch 28 des Rahmenschenkels 20 mittels eines einfachen Werkzeugs 40, während die Fig. 7 und 8 die Kontaktfeder 10 im eingebauten Zustand an einem rechten bzw. linken Rahmenschenkel wiedergeben.

Die Kontaktfeder 10 gemäß den Fig. 5 bis 8 ist mit einem Halteschenkel 2 und einem anderen Halteschenkel 3 im wesentlichen F-förmig eingebogen und in den Durchbruch 28 mit einer gewissen Spannung eingesetzt, wobei die Abmessungen des Durchbruches 28 an die offene Seite des V angepaßt sind und die Haltekrallen 4 und 5 dieKontaktfeder 10 auf der Innenseite der Wandung um den Durchbruch 28 festlegen. Die Haltekrallen 4 und 5 haben ferner die Aufgabe, beim Einsetzen mit dem Werkzeug 40 eine eventuelle Oberflächenschicht aufzukratzen und einen Kontakt mit dem Metall zu bilden.

Der Durchbruch 28 befindet sich in einem zum Schaltschrankinneren gerichteten und parallel zur Ebene der Montageplatte 30 verlaufenden Schenkel des Rahmenschenkels 20. An den einen Halteschenkel 2 der Kontaktfeder 10 ist ein zur angrenzenden Seitenwand des Schaltschrankes gerichteter Endabschnitt 1 angeschlossen, der flach auf dem Rahmenschenkel 20 anliegt, während der von der Seitenwand abliegende andere Halteschenkel 3 der Kontaktfeder 10 in einen ebenfalls an dem Rahmenschenkel 20 flach anliegenden Anlageabschnitt 6 übergeht, der sich in einem rechtwinklig dazu zur Rückwand 25 gerichteten weiteren Anlageabschnitt 7 fortsetzt. Der Anlageabschnitt 7 liegt ebenfalls flach auf der Außenseite des Rahmenschenkels 20 an dem zum Schaltschrankinnern gerichteten, senkrecht zur Rückwand 25 verlaufenden Profilschenkel an. Auf der zur Rückwand 25 gerichteten Seite ist der weitere Anlageabschnitt 7 im wesentlichen V-förmig oder U-förmig umgebogen, wobei die dem weiteren Anlageabschnitt 7 gegenüberliegenden Abschnitte Kontaktabschnitte 8 und 9 bilden. Die Kontaktabschnitte 8 und 9 bilden miteinander eine Kontaktkante 22', die an den Rand 33 der Montageplatte 30 in deren eingebautem Zustand unter Federspannung anliegt.

Der schräg in Richtung zu dem weiteren Anlageabschnitt 7 eingebogene endseitige Kontaktabschnitt 9 ergibt dabei eine federnde Einlaufschräge für die einzusetzende Montageplatte 30, so daß eine sichere Funktion gewährleistet ist.

Ist der Rand der Montageplatte 30 ebenfalls Oberflächenbeschichtet, so können an den Kontaktabschnitten 8 und 9, insbesondere in dem Bereich der Kontaktkante 22' ebenfalls krallenartige Vorsprünge vorgesehen sein, mit denen die Oberflächenschicht abgekratzt wird.

## Patentansprüche

1. Vorrichtung zum elektrisch leitenden Verbinden einer in einem Schaltschrank, Rahmengestell oder Gehäuse eingebauten Montageplatte, der zumindest auf einer Seite ein Rahmenschenkel (20), eine Montageschiene oder eine rahmenschenkelartige Abkantung einer Seitenwand zugeordnet ist, wobei die Montageplatte (30) am zugekehrten Rand (31) U-förmig abgekantet ist oder eine Verstärkung trägt, wobei zur Kontaktierung mindestens eine mehrfach abgekantete Kontaktfeder (10) verwendet ist, die mit U-förmigen und mit Haltekrallen (13) verbundenen Halteabschnitten (11, 12) an dem Endabschnitt (34) des Randes (31) oder der Verstärkung der Montageplatte (30) unter Herstellung einer elektrisch leitenden Verbindung angebracht ist, sich unter Vorspannung abstützt und an der Montageplatte (30) gehalten ist, und wobei sich an den außenliegenden Halteabschnitt (11) der Kontaktfeder (10) zwei Kontaktabschnitte (15, 16) anschließen, die eine Kontaktkante (22) bilden, die sich an dem Rahmenschenkel (20) der Montageschiene oder der Abkantung unter Vorspannung abstützt und, wobei der Rahmenschenkel (20) der Montageschiene oder der Abkantung mit elektrisch leitender Oberfläche versehen ist oder im Bereich der Kontaktkante (22) an der Kontaktfeder (10) zu dem Rahmenschenkel (20), der Montageschiene oder der Abkantung gerichtete Krallen vorgesehen sind,
dadurch gekennzeichnet,
daß der Rand (31) der Montageplatte (30) U-förmig so abgekantet ist,
daß der Endabschnitt (34) parallel zur Rückwand (25) verläuft und dieser zugekehrt ist,
daß die Kontaktfeder (10) mit den U-förmigen Halteabschnitten (11, 12) auf den Endabschnitt (34) aufgesteckt ist und
daß die Kontaktabschnitte (15, 16) den Rand der Montageplatte (30) teilweise umschließen.

2. Vorrichtung nach Anspruch 1,
dadurch gekennzeichnet,
daß die Haltekrallen (13) an dem innenliegenden Halteabschnitt (12) seitlich ausgestanzt und in Richtung zum außenliegenden Halteabschnitt (11) eingebogen sind.

3. Vorrichtung nach Anspruch 1 oder 2,
dadurch gekennzeichnet,
daß die Kontaktabschnitte (15, 16) breiter als die Halteabschnitte (11, 12) sind und
daß die Haltekrallen (13) in Richtung zum Ende des Endabschnittes (34) des Randes (31) der Montageplatte (30) gerichtet sind.

4. Vorrichtung nach einem der Ansprüche 1 bis 3,
dadurch gekennzeichnet,
daß die Kontaktabschnitte (15, 16) der Kontaktfeder (10) an den abgerundeten Übergängen des Mittelabschnittes (33) des Randes (31) der Montageplatte (30) außen anliegen.

5. Vorrichtung nach einem der Ansprüche 1 bis 4,
dadurch gekennzeichnet,
daß der der Rückwand (25) abgekehrte Kontaktabschnitt (16) der Kontaktfeder (10) als Anschlußabschnitt (17) verlängert ist, der eine Anschlußbohrung (19) aufweist und/oder in Aufsteckkontakten (18) endet, sowie in Richtung zur Kontaktkante (22) abgekantet ist.

6. Vorrichtung zum elektrisch leitenden Verbinden einer in einem Schaltschrank, Rahmengestell oder Gehäuse eingebauten Montageplatte, der zumindest auf einer Seite ein Rahmenschenkel (20), eine Montageschiene oder eine rahmenschenkelartige Abkantung einer Seitenwand zugeordnet ist, wobei zur Kontaktierung des Randes (33) der Montageplatte (30) mindestens eine mehrfach abgekantete Kontaktfeder (10) verwendet ist, die einerseits an einer Befestigungsstelle (28) an einem zur Ebene der Montageplatte (30) parallelen Abschnitt des Rahmenschenkels (20), der Montageschiene oder der rahmenschenkelartigen Abkantung kontaktierend festgelegt ist und andererseits an dem Rand (33) der eingebauten Montageplatte (30) federnd und kontaktierend abgestützt ist, und wobei zum Kontaktieren im Bereich der Befestigungsstelle (28) und/oder der Abstützstelle der Montageplatte (30) an der Kontaktfeder (10) Krallen (4, 5) vorgesehen sind, wobei an die Befestigungsstelle (28) anschließende Anlageabschnitte (1, 6) an dem parallelen Abschnitt anliegen und ein sich an den einen Anlageabschnitt (6) anschließender weiterer Anlageabschnitt (7) an einem dazu senkrechten, dem zugekehrten Rand (33) der Montageplatte (30) zugewandten Abschnitt des Rahmenschenkels (20), der Montageschiene oder der rahmenschenkelartigen Abkantung anliegt und wobei Kontaktabschnitte (8, 9) zwischen sich eine U- oder V-förmige Kontaktkante (22') bilden,
dadurch gekennzeichnet,
daß die Kontaktabschnitte (8, 9) U- oder V-förmig an dem weiteren Anlageabschnitt (7) abgebogen sind.

7. Vorrichtung nach Anspruch 6,
dadurch gekennzeichnet,
daß die Befestigungsstelle des Rahmenschenkels (20), der Montageschiene oder der rahmenschenkelartigen Abkantung als Durchbruch (28) mit einer an diesen angepaßten U- oder V-förmigen Abkantung ausgebildet ist, und
daß die Krallen (4, 5) die Wandung im eingesetzten Zustand hintergreifen.

## Claims

1. Apparatus for the electrically conductive connection of a mounting plate, which is incorporated in a switchgear cabinet, framework or housing and has associated therewith, at least on one side, a frame member (20), a mounting rail or a frame-member-like bent-over portion of a lateral wall, the mounting plate (30) being bent-over in a U-shaped manner at the facing edge (31) or having a reinforcement, at least one multiply bent-over contact spring (10) being used for contacting purposes, said spring being mounted, by means of U-shaped retaining portions (11, 12) which are connected to retaining claws (13), on the end portion (34) of the edge (31) or on the reinforcement of the mounting plate (30) so as to establish an electrically conductive connection, said spring being supported by initial tension and retained on the mounting plate (30), and two contact portions (15, 16) communicating with the externally situated retaining portion (11) of the contact spring (10), said contact portions forming a contact edge (22), which is supported by initial tension on the frame member (20) of the mounting rail or the bent-over portion, the frame member (20) of the mounting rail or of the bent-over portion being provided with an electrically conductive surface, or claws being provided in the region of the contact edge (22) on the contact spring (10), said claws being directed towards the frame member (20), the mounting rail or the bent-over portion, characterised in that the edge (31) of the mounting plate (30) is bent-over in a U-shaped manner so that the end portion (34) extends parallel to the rear wall (25) and faces said wall, in that the contact spring (10) is mounted on the end portion (34) by means of the U-shaped retaining portions (11, 12), and in that the contact portions (15, 16) partially surround the edge of the mounting plate (30).

2. Apparatus according to claim 1, characterised in that the retaining claws (13) on the internally situated retaining portion (12) are laterally punched-out and bent inwardly in the direction towards the externally situated retaining portion (11).

3. Apparatus according to claim 1 or 2, characterised in that the contact portions (15, 16) are wider than the retaining portions (11, 12), and in that the retaining claws (13) are directed towards the end of the end portion (34) of the edge (31) of the mounting plate (30).

4. Apparatus according to one of claims 1 to 3, characterised in that the contact portions (15, 16) of the contact spring (10) abut externally against the rounded-off transitional regions of the central portion (33) of the edge (31) of the mounting plate (30).

5. Apparatus according to one of claims 1 to 4, characterised in that the contact portion (16) of the contact spring (10) remote from the rear wall (25) is extended as connection portion (17), which has a connection bore (19) and/or terminates in mounting contacts (18), and said contact portion is bent-over in the direction towards the contact edge (22).

6. Apparatus for the electrically conductive connection of a mounting plate, which is incorporated in a switchgear cabinet, framework or housing and has associated therewith, at least on one side, a frame member (20), a mounting rail or a frame-member-like bent-over portion of a lateral wall, at least one multiply bent-over contact spring (10) being used to contact the edge (33) of the mounting plate (30), said spring, on the one hand, being contactingly secured at a mounting location (28) on a portion of the frame member (20), of the mounting rail or of the frame-member-like bent-over portion parallel to the plane of the mounting plate (30) and, on the other hand, being resiliently and contactingly supported on the edge (33) of the incorporated mounting plate (30), and claws (4, 5) being provided for contacting in the region of the mounting location (28) and/or of the supporting location of the mounting plate (30) on the contact spring (10), abutment portions (1, 6), which communicate with the mounting location (28), abutting against the parallel portion, and an additional abutment portion (7), which communicates with one abutment portion (6), abutting against a portion of the frame member (20), of the mounting rail or of the frame-member-like bent-over portion, which lies perpendicular to said portion (6) and faces the facing edge (33) of the mounting plate (30), and contact portions (8, 9) forming therebetween a U- or V-shaped contact edge (22'), characterised in that the contact portions (8, 9) are bent in a U- or V-shaped manner on the additional abutment portion (7).

7. Apparatus according to claim 6, characterised in that the mounting location of the frame member (20), of the mounting rail or of the frame-member-like bent-over portion is configured as opening (28) having a U- or V-shaped bent-over portion adapted thereto, and in that the claws (4, 5) engage behind the wall in their inserted position.

## Revendications

1. Dispositif de connexion électroconductrice d'une plaque de montage encastrée dans une armoire de distribution, dans une ossature d'encadrement ou dans un boîtier, dispositif auquel au moins d'un côté est associé une aile d'encadrement (20), un rail de montage ou un cintrage en aile d'encadrement d'une paroi latérale, où la plaque de montage (30) est, sur le bord (31) qui lui fait face, cintré en forme de U ou bien présente un épaississement, où pour l'établissement du contact est utilisée au moins une lame de contact (10) à plusieurs cintrages, lame qui par des tronçons de fixation en forme de U (11, 12) et reliés à des griffes de support (13) est fixée au tronçon terminal (34) du bord (31) ou de l'épaississement de la plaque de montage (30) avec établissement d'une connexion électroconductrice, qui s'appuie sous précontrainte et qui est maintenue appliquée à la plaque de montage (30), et où au tronçon de support extérieur (11) de la lame de contact (10) se raccordent deux tronçons de contact (15, 15), qui forment une arête de contact (22), laquelle s'applique sous précontrainte sur l'aile d'encadrement (20) du rail de montage ou sur l'arête, où l'aile d'encadrement (20) du rail de montage ou de l'arête est pourvu d'une surface électroconductrice ou bien où dans la région de l'arête de contact (22) sont prévus sur la lame de con,tact (10) des griffes orientées vers l'aile d'encadrement (20), vers le rail de montage ou vers l'arête,
caractérisé
en ce que le bord (31) de la plaque de montage (30) est cintré en forme de U de manière telle que le tronçon terminal (34) est parallèle à la paroi arrière (25) et est orienté vers cette dernière,
en ce que la lame de contact (10) est par les tronçons de support (11, 12) en forme de U enfichée sur le tronçon terminal (34) et
en ce que les tronçons de contact (15, 16) enserrent partiellement le bord de la plaque de montage (30).

2. Dispositif suivant la revendication 1,
caractérisé
en ce que les griffes de support (13) sont estampées latéralement sur le tronçon de support (12) intérieur et sont cintrées en direction du tronçon de support extérieur (11).

3. Dispositif suivant la revendication 1 ou 2,
caractérisé
en ce que les tronçons de contact (15, 16) sont plus larges que les tronçons de support (11, 12), et
en ce que les griffes de support (13) sont orientées en direction du bout du tronçon terminal (34) du bord (31) de la plaque de montage (30).

4. Dispositif suivant l'une quelconque des revendications de 1 à 3,
caractérisé
en ce que les tronçons de contact (15, 16) de la lame de contact (10) sont appliqués extérieurement aux zones de transition arrondies du tronçon médian (33) du bord (31) de la plaque de pontage (30).

5. Dispositif suivant l'une quelconque des revendications de 1 à 4,
caractérisé
en ce que le tronçon de contact (16), orienté vers la paroi arrière (25), de la lame de contact (10) est prolongé en tant que tronçon de raccordement présentant une forure de raccordement (19) et/ou se termine par des contacts d'enfichage (18), et est coudé en direction de l'arête de contact (22).

6. Dispositif de connexion électroconductrice d'une plaque de montage encastrée dans une armoire de distribution, dans une ossature d'encadrement ou dans un boîtier, dispositif auquel au moins d'un côté est associé une aile d'encadrement (20), un rail de montage ou un cintrage en aile d'encadrement d'une paroi latérale, où pour contacter le bord (33) de la plaque de montage (30) est utilisé au moins une lame de contact (10) à plusieurs cintrages, lame qui d'une part est au niveau du point de fixation (28) est appliquée avec contact électrique à un tronçon, parallèle à la plaque de montage (30), de l'aile d'encadrement, du rail de contact ou du cintrage en aile d'encadrement, et qui d'autre part est appliquée élastiquement et avec contact électrique sur le bord (33) de la plaque de montage (30) encastrée, et où pour établir le contact il est prévu des griffes (4, 5) dans la zone du point de fixation (28) et/ou la zone d'étayage de la plaque de montage (30) sur la lame de contact (10), et où des tronçons d'application (1, 6) se raccordant au point de fixation (28) sont appliqués contre le tronçon parallèle et où un tronçon d'application additionnel (7) raccordé au tronçon d'application (6) est appliqué contre un tronçon qui lui est perpendiculaire et orienté vers le bord (33) de la plaque de montage (30), de l'aile d'encadrement (20), du rail de montage ou du cintrage en forme d'aile d'encadrement, et où les tronçons de contact (8, 9) constituent ensemble une arête de contact (22') en forme de U ou de V,
caractérisé
en ce que les tronçons de contact (8, 9) sont cintrés en forme de U ou de V sur le tronçon d'application (7) additionnel.

7. Dispositif suivant la revendication 6,
caractérisé
en ce que le point de fixation de l'aile d'encadrement (20), du rail de montage ou du cintrage en forme d'aile d'encadrement a la forme d'un percement (28) avec un cintrage en forme de U ou de V adapté à ce percement, et
en ce que, en position de service, les griffes (4, 5) viennent s'engager derrière la paroi.
